# EUROPEAN PATENT APPLICATION

(11) **EP 1 100 298 A1**
(43) Date of publication of application: **16.05.2001**
(21) Application number: 00917296.6
(22) Date of filing: 12.04.2000
(51) Int. Cl.: H05K 3/40, H05K 1/11, H05K 1/09, H05K 3/12, H05K 3/24

(54) **CERAMIC CIRCUIT BOARD AND METHOD OF MANUFACTURE THEREOF**

(30) Priority: 15.04.1999 JP 10841599
(71) Applicant: Matsushita Electric Industrial Co., Ltd., Kadoma-shi, Osaka 571-8501 (JP)
(72) Inventor: SEGAWA, Shigetoshi, Niihama-shi, Ehime 792-0050 (JP); OCHI, Hiroshi, Saijo-shi, Ehime 793-0043 (JP)
(74) Representative: Kügele, Bernhard
(86) International application number: JP0002383
(87) International publication number: WO0064226

(57) **Abstract**

A method of manufacturing a ceramic board includes two process steps; applying a first conductor paste in a recess occurred in each via-hole of the ceramic substrate after conductor materials are filled in the via-holes and fired, and forming a surface circuit by printing a second conductor paste for forming the surface circuit. A viscosity of the first conductor paste is lower than that of the second conductor paste. With the prevent invention, there is good conduction between the surface circuit and the conductor in each via-hole, and further a printing pattern of the surface circuit around each via-hole has high accuracy. As a result, the highly reliable ceramic circuit board, which is adequate to a high-density circuit, can be provided.

## Description

### FIELD OF THE INVENTION

The invention relates to a ceramic circuit board used in high density wiring circuit board and a method of manufacturing the ceramic circuit board.

### BACKGROUND OF THE INVENTION

In various kinds of electronic devices, a ceramic circuit board is used to downsize the circuit. Via holes are used to connect conductor circuits on both surfaces of a ceramic substrate, to shorten a circuit conductor or to connect conductor circuits in each layer of a multi-layer circuit board.

The via-hole is a fine hole penetrating through the ceramic substrate. The via-hole is filled with conductor paste and fired. The conductor filled in the via-hole can connect conductor circuits in each layer or connect circuits on the surface of the substrate.

The conductor paste filled in each via-hole is often co-fired with ceramic green sheet forming the ceramic substrate.

A surface circuit on the ceramic circuit board is formed by printing conductor paste thereon and further by firing the conductor paste after firing the green sheet or a laminate of green sheets.

However, in the above-mentioned method of manufacturing a conventional ceramic circuit board, there are problems such as poor conduction between the conductor filled in the via-holes and the surface circuit, or failures occurring in the surface circuit formed on the part of each via-hole.

One cause of the failures is considered that the conductor paste filled in the via-hole shrinks by firing and is recessed from an opening end of the via-hole. As there is a large difference between the green sheet and the conductive paste in shrinkage, when the green sheet and the conductor paste in the via-hole are fired simultaneously, the conductor paste having large shrinkage is recessed from the opening end of each via-hole.

When conductor paste for a surface circuit is printed on the green sheet with a recess in the opening end of each via-hole, the conductor paste is not enough filled into the recess of each via-hole. Therefore, there are problems that a hollow takes place between the conductor in each via-hole and the conductor paste for the surface circuit, or printing-pattern distortion and blur occur on the periphery of each via-hole.

For improving accuracy of wiring at printing, a paste with relatively high viscosity is used for the conductor paste forming the surface circuit to prevent running and dripping of the paste. Recently, a high density circuit is demanded in particular, therefore, a further high-viscosity conductor paste is demanded.

However, it is difficult to fill the high-viscosity conductor paste in a small recess of each via-hole by printing sufficiently. Furthermore, by the effect of surface tension of the conductor paste, the so-called repel occurs on the edge of the via-hole and the conductor paste can not reach into the via-hole. Thus, the above problems often occur.

The purpose of the present invention is to provide a ceramic circuit board that can provide good conduction between the conductor in the via-hole and the surface circuit at a point of each via-hole and can prevent surface circuit failures occur around each via-holes.

### DISCLOSURE OF THE INVENTION

A method of manufacturing a ceramic circuit board of the present invention includes two process steps;
a process of applying a first conductor paste on a recessed part of a conductor materials filled via-hole in a fired ceramic substrate, and
a process of forming a surface circuit by printing a second conductor paste for making the surface circuit on the ceramic substrate, the recessed part thereof filled with the first conductor paste,
   wherein, a viscosity of the first conductor paste is lower than that of the second conductor paste.

With the method of manufacturing of the prevent invention, there is good conduction between the surface circuit conductor and the conductor in the via-hole, and high accuracy of printing pattern of the surface circuit on the periphery of each via-hole can be achieved. Consequently, the ceramic circuit board with good reliability and applicable for high density circuit can be provided

### BRIEF DESCRIPTION OF THE DRAWINGS

Fig. 1 is a cross sectional view of a intermediate product of a ceramic circuit board and a printing mask showing a method of manufacturing of the present invention.
Fig. 2 is a cross sectional view of main portion of the ceramic circuit board showing each step of the manufacturing process of the present invention.
Fig. 3 is a plan view showing the part around the via-hole of the ceramic circuit board of the present invention.

### DESCRIPTION OF THE PREFERRED EMBODIMENTS

A method of manufacturing a ceramic circuit board of present invention is described hereinafter.

The method of manufacturing the ceramic circuit board of the present invention includes fundamentally two process steps below;
1. A first process of applying a first low-viscosity conductor paste so as to cover the via-hole in a fired substrate into which a conductor paste was filled when the substrate was a green sheet.
2. A second process of forming a surface circuit by printing a second conductor paste for the surface circuit over the first conductor paste.

Materials used in the present invention are described in detail below.

### [Substrate]

Materials and construction used for a conventional ceramic circuit board can be used in the substrate of the present invention. More specifically, the ceramic circuit board can be formed of ceramic materials, such as alumina, silicon nitride, silicon carbide and glass ceramics.

The via-holes are bored by well known means through the green sheet made of the above ceramic materials, binder resins and plasticizer, and the conductor paste is filled in each via-hole. The via-hole is about 0.1 to 0.3 mm in diameter. The used conductor paste includes at least conductors, binder resins and a small amount of binding agents, and also the conventional conductor paste for filling the via-holes is used.

When manufacturing a multi-layer circuit board, a plurality of green sheets is laminated. A conductor circuit is formed on the surface of each green sheet. The conductor circuit is formed by printing a conductor paste on the required portions to make inner layer circuits. As the conductor paste in each via-hole do not shrink at this step, there are no step portions or recesses between the opening end of the via-hole and the periphery of each via-hole. Therefore, the good coupling is provided between the conductor paste on the surface of the green sheet and the conductor paste inside the via-hole.

In a laminate of green sheets constructing the multi-layer circuit board, there are three types of via-holes filled with the conductor paste.

A first via-hole penetrates through the laminate from the top to the bottom. A second via-hole passes through the laminate from one surface to partway and is stopped in partway. A third via-hole passes through only inside the laminate and is not exposed to the outside. The via-hole exposed to at least one of both surfaces relates to a formation of a surface circuit.

The green sheet or the laminate of the green sheets is fired through the conventional firing process. The conductor paste filled inside the via-holes is simultaneously fired. Then, as there is a shrinkage difference between the green sheet and the conductor paste inside the via-hole, the surface of the conductor inside the via-hole is recessed from the opening end of the via-hole. The recess is usually 5 to 100 µm in depth.

### [First Conductor Paste]

A first conductor paste with low-viscosity is used to fill the recess in the surface of the conductor at the opening end of the above via-hole.

The essential materials and composition may be the same as the second conductor paste for forming the conventional circuit. However, controlling the amount of solvent can produce the first conductor paste having lower viscosity as compared with the second conductor paste. Adding solvent to the second conductor paste, for example, can produce the first conductor paste with low viscosity.

The viscosity of the first conductor paste varies in accordance with the conditions, such as depth and size of the recess at the top of the via-hole or the viscosity of the conductor paste used for the surface circuit. The first conductor paste which is 50 to 100 Pa · s in viscosity can be used. According to the experimental data obtained by the inventors, the viscosity of the first conductor paste is preferably 10 - 70 % of the viscosity of the second conductor paste. More preferably, the viscosity of the first conductor paste is 30-50% of the viscosity of the second conductor paste.

The viscosity of not more than 10% is disadvantageous to form a high-definition circuit because a printed pattern spreads. The viscosity over 70% may produce a poor connection as in the conventional production method.

The surface circuit may be produced with the first conductor paste simultaneously in a portion where high accuracy wiring is unnecessary. In this case, the first conductor paste is adjusted at a viscosity capable of forming the surface circuit. As a result, it is unnecessary to changes two kinds of conductor pastes when producing the circuit board. However, it is difficult to form a pattern where high density wiring and high accuracy is required by using the first conductor paste.

Printing means such as a conventional screen-printing is used to fill the first conductor paste in the recessed part of the via-hole. In the screen mask, openings are made in the place corresponding to the recessed part of each via-hole. A dispenser may also be used in the laminate with the small number of via-holes.

Regarding an applying amount of the first conductor paste, the recess of the opening in each via-hole does not need to be filled completely but needs to be filled to the level where problems with formation of the surface circuit do not occur.

The first conductor paste with low viscosity may be applied only on the opening of the via-hole, however, it is preferable that the first conductor paste is applied so as to slightly spread out of the via-hole. The recessed parts are reliably filled by slightly spreading the first conductor paste out of the via-hole even when a dimensional error of the via-hole and error or shear in printing of the low-viscosity conductor paste occur. The first conductor paste applied so as to spread out of the via-hole may protrude from the ceramic substrate unless the protrusion interferes the printing of the surface circuit. The above protrusion can be adjusted to 5-10 µm, however, when the first conductor paste applied over the via-hole excessively spreads out of the via-hole, the first conductor paste becomes in contact with adjacent surface circuits and the function of the surface circuit may be impaired. Therefore, the printing diameter of the first conductor paste is preferably adjusted to 0.8-3.0 times of the diameter of the via-hole, more preferably, 1.0-2.0 times. In consideration of actual size of the circuit, more specifically, printing of the first conductor paste is adjusted to be 0.2-0.4 mm in diameter.

Furthermore, materials to improve connection between the conductor filled in the via-hole and the conductor for the surface circuit may be used for the first conductor paste.

For example, when problem-prone combination happens between the conductor of surface circuit and the conductor formed by filling in each via-holes by contacting each other, using the low-viscosity conductor paste made of conductor materials which make good contact with both of the conductors can improve the above problems.

More specifically , when the electrode potentials of both conductor metals are greatly different and formation of partial cell are foreseen, a use of a metal having a middle potential as a conductor of the first conductor paste prevent the formation of partial cell, thus preventing a corrosion of the metal at a contacting interface. This enables a wide range selection of a conductor metal in the via-hole.

### [Formation of Surface Circuit]

The surface circuit is formed by printing the conductor paste for the surface circuit over the ceramic substrate by a conventional printing means before drying the first conductor paste coated over the via-hole or after drying.

The surface circuit may be formed so as to completely cover the first conductor paste and also a part of the first conductor paste may be exposed if the surface circuit is in good connection with the conductor filled in the via-hole via the first conductor paste. As described above, when a part of the surface circuit is constructed by the first conductor paste, there may be the cases where the conductor paste for surface circuit is not printed over the via-holes

As the second conductor paste, a paste with 100-500 Pa · s of viscosity is generally used. Printing diameter of the second conductor paste, which covers the first conductor paste for the via-hole, is adjusted to be 0.3-0.5 mm in diameter.

The ceramic substrate printed the second conductor paste undergoes a conventional firing process, and the first conductor paste and the second conductor paste are fired. Thus, a ceramic circuit board having the surface circuits is produced.

Embodiments of the present invention are described with reference to drawings in the following.

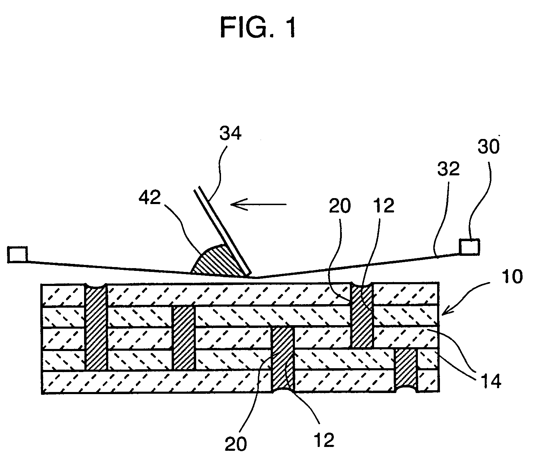

Fig. 1 shows the method of manufacturing a multi-layer ceramic circuit board.

Ceramic substrate 10 is a multi-layer substrate integrated by laminating a plurality of green sheets 14 and firing. In Fig. 1, each of green sheets 14 is independently shown. In practice, in fired ceramic substrate 10, a plurality of green sheets 14 are completely integrated. Via-holes 12 passing through a plurality of layers are disposed in ceramic board 10. Internal conductor 20 is filled in each via-hole.

In the process of laminating green sheets one by one, the second conductor paste is filled in via-hole 12 where it is needed. After laminating all of green sheets 14, green sheets 14 are fired and internal conductor 20 also is fired simultaneously.

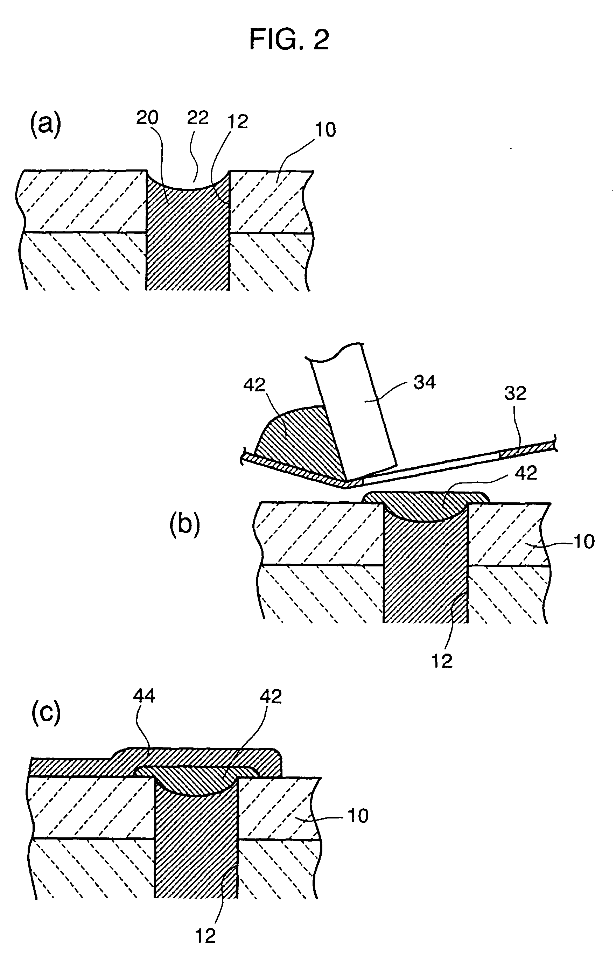

As shown the details in Fig. 2(a), a surface of internal conductor 20 in via-hole 12 is slightly recessed from the opening end of via-hole 20, and thus recess 22 is formed. Recess 22 occurs from the difference of shrinkage between green sheet 14 and the conductor paste in via-hole 12 in the process of firing green sheet 14 when producing ceramic substrate 10.

As shown in Fig.1, printing-screen frame 30 is disposed over the surface of ceramic substrate 10 and first conductor paste 42 is placed on screen 32. Conductor paste 42 is printed in recess 12 in via-hole 12 by moving squeegee 34.

As shown in details in Fig. 2(b) , conductor paste 42 is printed so as to slightly spread out of the opening of via-hole 12 and slightly protrude from the surface of ceramic substrate 10.

Furthermore, as shown in Fig. 2(c), the surface circuit is formed by printing conductor paste 44 for the conventional surface circuit over conductor paste 42 . Conductor paste 44 is printed in the next larger area than that of conductor paste 42 and completely covers conductor paste 42.

A high-accuracy surface circuit is readily formed on the surface of ceramic substrate 10 because, though, the slightly protruding parts by conductor paste 42 are on the surface, the surface is nearly flat all over the substrate. Conductor paste 44 is reliably coupled to internal conductor 20 via conductor paste 42 at via-hole 12. Therefore, there are no problems caused by above-mentioned recess 22.

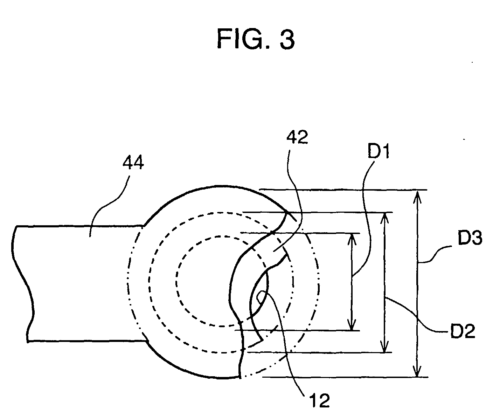

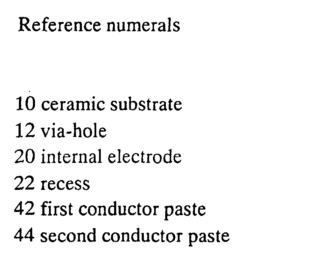

Fig. 3 is a plan view showing the periphery of via-hole 12 produced via the above process. As shown in Fig. 3, outer diameter D2 of conductor paste 42 and outer diameter D3 of conductor paste 44 increase in stages to diameter D1 of via-hole 12.

Then ceramic substrate 10 with printed conductor paste 44 undergoes the process of firing and conductor paste 42 and conductor paste 44 are fired. Conditions of firing may be as in the case of forming conventional surface circuit.

The ceramic circuit board produced as described above has good conduction between the surface circuit and an internal circuit of each via-hole and has the surface circuits with high circuit accuracy. Consequently, a good-quality and high-accuracy ceramic circuit board can be provided.

The ceramic circuit board is produced as a specific example and evaluated in performance as follows.

### EXAMPLE 1

Laminating a plurality of glass ceramic green sheets and firing the laminate produces a ceramic multi-layer substrate.

The green sheets disposed on at least both sides of green sheets forming the ceramic multi-layer substrate have via-holes of not less than 1000 in number. A conductor paste for a conventional internal conductor is filled in each via-hole.

As a result, via-holes of 0.15 mm in diameter and not less than 1000 in number are in the surface of the ceramic multi-layer substrate.

A first conductor paste, Ag/Pd conductor paste of 70 Pa · s in viscosity, is screen printed over each via-hole in the ceramic multi-layer substrate. The printing pattern is 0.2 mm in diameter. After printing the conductor paste, the ceramic multi-layer substrate is dried for 10 minutes at 150 °C.

Furthermore, a surface circuit is screen printed with Ag/Pd conductor paste of 250Pa · s in viscosity, which has the same composition as the first conductor paste. Then the top of the first conductor paste in each via-hole is covered with a second conductor paste. The printing pattern of the second paste in each via-hole is 0.3 mm in diameter. After printing the second conductor paste, ceramic multi-layer substrate is dried for 10 minutes at 150 °C.

The ceramic multi-layer substrate printed with the surface circuit is fired for 15 minutes at 850 °C to provide a ceramic circuit board.

### COMPARATIVE EXAMPLE 1

In above example, a ceramic circuit board is produced via the same processes as example 1 but the second conductor paste is used and the first conductor paste is not used.

### [Evaluation of Performance]

Appearance and electrical performance on ceramic circuit boards in example 1 and comparative example 1 are evaluated. Table 1 shows the results. In items of evaluation, an appearance failure is determined by a visual check whether the phenomenon of repel occurs around each via-hole. A conduction failure is determined by a conventional conduction test on the conductor filled in each via-hole. A number shows the number of failure every 1000 via-holes.

**Table 1**

| | Appearance failures | Conduction failures |
|---|---|---|
| Example 1 | 0 | 0 |
| Comparative example 1 | 55 | 12 |
| Unit; the number every 1000 via-holes | | |

Table 1 shows that a combined use of the first conductor paste and the second conductor paste in the example of the present invention substantially decreases appearance failure and conduction failure.

As described above, in the method of manufacturing the ceramic circuit board in the present invention, a recess in the via-hole filled with the conductor is filled by printing the conductor paste and then the second conductor paste is printed to form the surface circuit. Therefore, there is good conduction between the surface circuit and the conductor in each via-hole and the surface circuit around each via-hole can be made with high accuracy. Thus, the present invention can provide the ceramic circuit board having high circuit accuracy and high reliability with high productivity.

## Claims

1. A method of manufacturing a ceramic circuit board comprising;
applying a first conductor paste over a via-hole of a ceramic substrate filled with a conductor; and
forming a surface circuit by printing a second conductor paste for forming the surface circuit over said first conductor paste,
wherein a viscosity of said first conductor paste is lower than a viscosity of said second conductor paste.

2. The method of manufacturing the ceramic circuit board of claim 1, where the viscosity of said first conductor paste is 50-100 Pa · s.

3. The method of manufacturing the ceramic circuit board of claim 1 or claim 2, wherein the viscosity of said first conductor paste is 10-70 % of the viscosity of said second conductor paste.

4. The method of manufacturing the ceramic circuit board of any one of claim 1 to 3, wherein an application diameter of said first conductor paste is 0.3-3.0 times of a diameter of said via-hole.

5. The method of manufacturing the ceramic circuit board of claim 4, wherein said via-hole is 0.1-0.3 mm in diameter.

6. The method of manufacturing the ceramic circuit board of any one of claim 1 to 3, wherein a conductor composition of said first conductor paste is different from a conductor composition of said second conductor.

7. A ceramic circuit board, in which conductors consisting said circuit comprising;
a first conductor filled in a via-hole;
a second conductor covering the first conductor filled in said via-hole ; and
a third conductor covering said second conductor,
wherein a conductor composition of said first conductor is different from a conductor composition of said second conductor.

8. The ceramic circuit board of claim 7,
wherein the conductor composition of said second conductor is further different from a conductor composition of said third conductor.
